## Europäisches Patentamt
(19) **European Patent Office**
**Office européen des brevets**

(11) Numéro de publication: **0 065 443 B1**

## (12) FASCICULE DE BREVET EUROPEEN

(45) Date de publication du fascicule du brevet:
23.01.85

(51) Int. Cl.⁴: **H 01 L 23/56,** H 01 L 23/04

(21) Numéro de dépôt: **82400785.0**

(22) Date de dépôt: **29.04.82**

(54) **Boîtier d'encapsulation pour semiconducteur de puissance fonctionnant dans une gamme de fréquences de 2 à 20 GHz.**

(30) Priorité: **19.05.81 FR 8109935**

(43) Date de publication de la demande:
**24.11.82 Bulletin 82/47**

(45) Mention de la délivrance du brevet:
**23.01.85 Bulletin 85/4**

(84) Etats contractants désignés:
**DE GB NL**

(56) Documents cités:
**FR - A - 2 376 520**
**US - A - 4 038 157**
**US - A - 4 177 480**

**29TH ELECTRONIC COMPONENTS CONFERENCE;**
**14-16 mai 1979, Cherry Hill, N.J. (US) H.N.**
**Keller:"Reliability of clip-on terminals soldered to**
**Ta-Ta2N-NiCr-Pd-Au thin films", pp.99-105**
**ELECTRICAL DESIGN NEWS, vol.14, no.18, 15**
**septembre 1969, Denver (US) J.J. Cox et al.:"An**
**up-to-date look at thick films", pp.35-42**

(73) Titulaire: **THOMSON-CSF, 173, Boulevard Haussmann, F-75379 Paris Cedex 08 (FR)**

(72) Inventeur: **Carnez, Bernard, THOMSON-CSF SCPI 173, bld Haussmann, F-75379 Paris Cedex 08 (FR)**
Inventeur: **Bessonneau, Guy, THOMSON-CSF SCPI 173, bld Haussmann, F-75379 Paris Cedex 08 (FR)**
Inventeur: **Derewonko, Henri, THOMSON-CSF SCPI 173, bld Haussmann, F-75379 Paris Cedex 08 (FR)**
Inventeur: **Chambaudu, Georges, THOMSON-CSF SCPI 173, bld Haussmann, F-75379 Paris Cedex 08 (FR)**

(74) Mandataire: **Taboureau, James et al, THOMSON-CSF SCPI 173, Bld Haussmann, F-75379 Paris Cedex 08 (FR)**

## Description

L'invention concerne un boîtier d'encapsulation pour des semicon ducteurs de puissance fonctionnant aux très hautes fréquences, de l'ordre de 2 à 20 GHz ou davantage. Elle concerne plus particulièrement l'isolement entre les connexions d'entrée et de sortie des semiconducteurs encapsulés dans un tel boîtier.

Les semiconducteurs concernés par l'invention sont principalement ceux qui sont réalisés en matériau de type III-V, c'est-à-dire GaAs, $Al_x$. $Ga_yAs_z$, et les composés voisins avec In, P, Sb ... sous les différentes formes connues, tous ces semiconducteurs travaillant à des fréquences très élevées supérieures à 1 GHz. Les semiconducteurs réalisés sur un substrat de silicium sont susceptibles d'être encapsulés dans des boîtiers selon l'invention, mais la fréquence maximale à laquelle ils travaillent, inférieure de toutes façons à 5 GHz, fait qu'ils ne sont pas concernés par les mêmes problèmes.

Le problème pour les semiconducteurs concernés par l'invention, et qui en vue de simplifier le texte qui suit seront appelés de façon générique et non exaustive semiconducteurs sur GaAs, est un problème de couplage entre les connexions d'entrée et de sortie sur les boîtiers de puissance. Pour de tels semiconducteurs, le boîtier comporte, outre une embase généralement métallique pour dissiper les calories dégagées, au moins un cadre céramique à travers l'épaisseur duquel passent des connexions d'accès extérieures au semiconducteur, le boîtier étant refermé par un couvercle céramique. Ce couvercle en céramique est fixé au boîtier par l'intermédiaire d'un cordon de soudure déposée sous forme d'un ruban sur le cadre, cordon de soudure qui fait le tour du boîtier. Entre chaque connexion externe, qui est métallique, et le ruban de soudure se forme au croisement de ces deux pièces, un condensateur parasite, deux condensateurs parasites sur deux connexions externes étant électriquement réunis par le ruban de soudure. Il en résulte un phénomène de couplage entre les connexions d'entrée et de sortie, le signal prélevé par un condensateur parasite sur une connexion d'entrée étant transmis sur une connexion de sortie par un autre condensateur parasite, ce signal ayant chaminé le long du cordon de soudure. Ce phénomène de couplage crée, en fonction de la forme et des dimensions du boîtier ainsi que des fréquences de travail du semiconducteur, des résonances à certaines fréquences, qui détériorent les caractéristique d'isolement entre les connexions externes concernées.

Ce problème se manifeste essentiellement pour les boîtiers de puissance pour lesquels la liaison métallique entre deux condensateurs parasites, c'est à dire entre deux connexions externes, est d'une longueur de l'ordre du centimètre, tandis que pour les boîtiers d'encapsulation de semiconducteur de faible puissance, la longueur étant de l'ordre de 2 à 3 mm environ, le phénomène de couplage par condensateur parasite est de beaucoup moins important, les résonances intervenant à des fréquences beaucoup plus élevées. Sur les boîtiers de puissance, la longueur de la métallisation de soudure du couvercle présente un chemin dont a longueur n'est pas négligeable devant la longueur d'onde.

La solution apportée à ce problème de détérioration de l'isolement entre les connexions d'entrée et de sortie consiste en une métallisation résistive d'une surface du couvercle céramique, métallisation qui englobe les tranches latérales de la plaquette de céramique qui constitue le couvercle, et qui est en contact électrique avec le dépôt ou la préforme de soudure tendre prévue pour souder le couvercle sur le boîtier. La liaison directe entre les condensateurs parasites est remplacée par une ligne à petes dont la résistance très élevée de la métallisation atténue très fortement le couplage entre les condensateurs parasites sur les connexions d'entrée et de sortie. Aux fréquences concernées de 1 à 100 GHz environ, le mode de propagation des ondes électriques dans ou sur la céramique du couvercle et dans la couche résistive fait que le cordon de soudure ne constitue pas un court-circuit à la métallisation résistive.

De façon plus précise, l'invention concerne un boîtier d'encapsulation pour semiconducteur de puissance fonctionnant dans une gamme de fréquences de 2 à 20 GHz, comprenant une embase sur laquelle est fixée la pastille semiconductrice, un cadre isolant à travers lequel passent au moins deux connexions externes d'accès au semiconducteur, dites d'entrée et de sortie, et un couvercle isolant, le couvercle étant fixé sur le cadre par soudure au moyen d'une métallisation déposée sur la face libre du cadre et d'une métallisation déposée sur la face du couvercle en regard du cadre, ce boîtier d'encapsulation étant caractérisé en ce que le couvercle est recouvert par une métallisation résistive, déposée sur le matériau isolant du couvercle, et en contact électrique avec la métallisation destinée à la fermeture du boîtier.

L'invention sera mieux comprise par la description d'un exemple d'application qui suit, cette description s'appuyant sur les figures jointes qui représentent:

- figure 1: vue en éclaté d'un boîtier de puissance pour semiconducteurs de type GaAs;
- figure 2: schéma de couplage entre les connexions d'entrée et de sortie, dans un boîtier fonctionnant entre 2 et 20 GHz;
- figure 3: courbe d'isolement entre les connexions d'entrée et de sortie, en fonction de la fréquence, dans un boîtier selon l'art connu;
- figure 4: schéma de métallisation d'un couvercle céramique, selon l'invention;
- figure 5: courbe d'isolement entre les connexions d'entrée et de sortie en fonction de la fréquence, dans un boîtier selon l'invention.

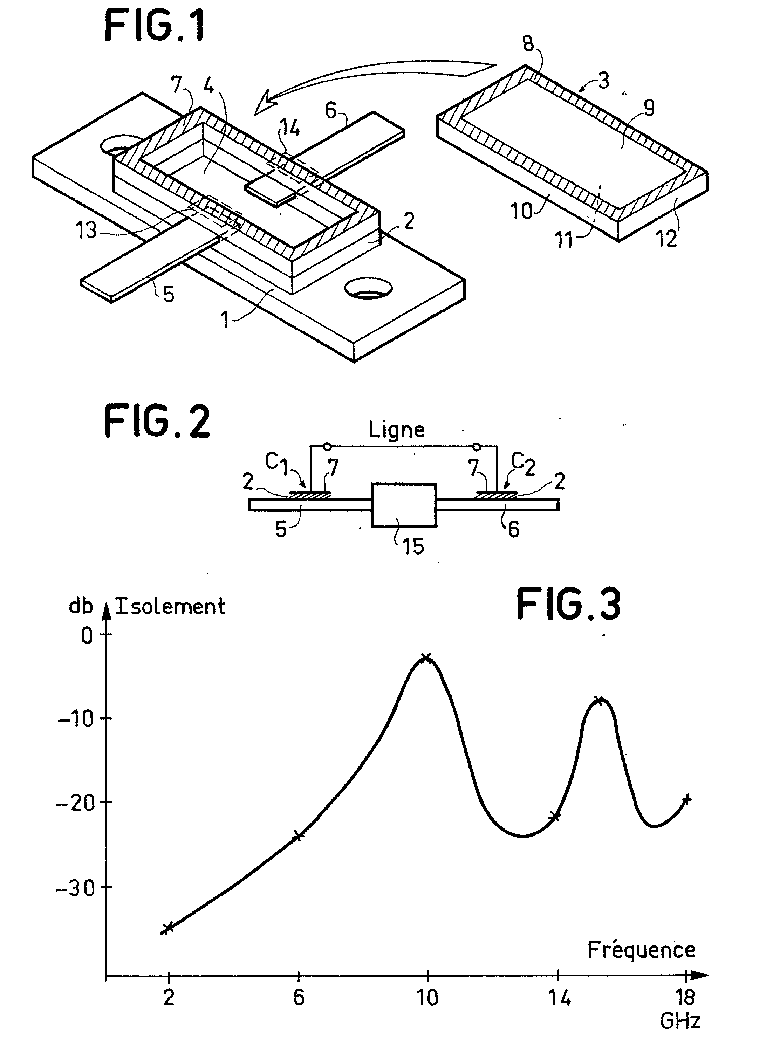

La figure représente une vue dans l'espace d'un boîtier de puissance pour semiconducteurs travaillant à de très hautes fréquences, le couvercle de ce boîtier ayant été ôté de façon à mieux montrer la structure du boîtier. Pour former un boîtier étanche, à partir des éléments représentés sur la figure 1, il est nécessaire de faire subir au couvercle une rotation et le souder sur l'embase de boîtier.

Pour un tel boîtier de puissance représenté ici dans une forme rectangulaire sans que cela soit limitatif puisque d'autres formes rondes ou carrées existent également, les pièces principales sont:

— une embase 1 généralement métallique, en cuivre ou en laiton,
— un cadre isolant 2 en céramique ou en alumine,
— un couvercle 3, également en céramique ou en alumine.

Le boîtier ainsi constitué lorsqu'il est terminé et refermé délimite donc une enceinte étanche 4 dans laquelle un semiconducteur de puissance, qui n'a pas été représenté car il n'est pas indispensable aux explications suivantes, est fixé sur l'embase 1 avec ou sans intermédiaire d'une dalle isolante en oxyde de beryllium. Le semiconducteur encapsulé, s'il comporte trois électrodes comme c'est le cas le plus général, est électriquement relié à l'embase 1 qui constitue une électrode d'accès, tandis que deux électrodes ou connexions externes 5 et 6 sont reliées par des fils d'or à la pastille de semiconducteur. Ce sont ces deux connexions externes 5 et 6 qui sont appelées dans la suite de ce texte les connexions d'entrée et de sortie. Elles sont isolées de l'embase parce qu'elles traversent le cadre 2 en céramique, lequel est le plus fréquemment constitué de deux cadres superposés puis réunis mécaniquement à l'exclusion de toute brasure ou soudure. La face libre du cadre 2, c'est-à-dire celle qui n'est pas en contact avec l'embase l'est métallisée en 7 de façon à ce qu'une soudure extérieure puisse adhérer sur la couche métallique 7, chose qui serait impossible si le cadre n'était pas métallisé.

Le couvercle 3 est le plus fréquemment constitué par une plaquette de céramique ou d'alumine, laquelle porte également un cadre 8 de métallisation, de même format que le cadre métallisé 7, sur l'une des faces 9 de la plaquette d'alumine ou de céramique. La tranche latérale 10 de cette plaquette et sa seconde face 11, cachée sur la figure 1 et qui constitue la face externe du couvercle après soudure, sont isolantes puisque ce sont des faces de céramique.

Les connexions externes d'entrée et de sortie 5 et 6 théoriquement très bien isolées puisqu'elles sonts prises dans une masse de céramique. En fait, à l'endroit où chacune de ces connexions traverse le cadre 2 il se forme un condensateur parasite dont une armature est constituée par le ruban métallique de la connexion 5 ou 6 et dont l'autre armature est constituée par une partie, 13 ou 14 représentée en pointillé sur la figure 1, du ruban de métallisation 7.

La figure 2, qui représente le schéma de couplage entre les connexions d'entrée et de sortie dans un boîtier, permettra de mieux compendre comment est détériorée l'isolation des connexions d'entrée et de sortie, par un couvercle électriquement isolant.

Soit un quadripôle 15 que l'on a schématiquement représenté par un rectangle sur la figure 2, et soient deux quelconques de ses connexions d'entrée et de sortie 5 et 6. Ces connexions d'entrée et de sortie sont plus fréquemment constituées par un ruban métallique que par un fil. A l'endroit où lesdites connexions d'entrée et de sortie traversent le cadre céramique 2, il se forme entre ces rubans et la bande de métallisation 7 deux condensateurs parasites, dont le diélectrique est constitué par la céramique du cadre 2. Ces deux condensateurs parasites sont mis en liaison par l'intermédiaire de la métallisation 7, et même plus exactement par l'ensemble des deux métallisations 7 et 8 et de la préforme de soudure qui permet de fixer le couvercle 3 sur le boîtier d'encapsulation du semiconducteur. Il s'agit donc d'une liaison par ligne de propagation dont la longueur correspond au demi périmètre de la métallisation 7 ou encore au demi périmètre du cadre 2 présente un chemin dont la longueur n'est par négligeable devant la longueur d'onde puisque le semiconducteur travaille à très hautes fréquences. Ainsi, un signal d'entrée par exemple sur la connexion externe 5 est transmis par l'intermédiaire du condensateur $C_1$ et de la ligne de propagation constituée par la métallisation 7 à la connexion de sortie 6 par l'intermédiaire du condensateur $C_2$.

Les solutions connues dans le domaine de l'encapsulation de semiconducteurs ne sont pas applicables au cas présent où le semiconducteur est à base de GaAs ou d'un composé analogue. Par exemple le remplacement des métallisations 7 et 8 et de la préforme de soudure pour fermer le capot pat un collage par une résine époxy ou polyester n'est pas possible car de telles colles dégradent les métallisations et la pastille d'arséniure de gallium. La fermeture du couvercle par un procédé comparable au procédé dit CERDIP, utilisant deux préformes de verre à bas point de fusion est impossible également, car le procédé CERDIP nécessite au chauffage à 800°C pour ramollir le verre, ce qui est impossible dans le cas de l'arséniure de gallium. Le remplacement du couvercle 3 en céramique par un couvercle de forme tout à fait comparable mais découpé dans une plaque métallique n'apporte pas une solution réelle au problème de couplage entre les connexions d'entrée et de sortie. En effet, un tel couvercle ne présente aucune résistance et n'atténue nullement le couplage entre les condensateurs parasites sur les connexions d'entrée et de sortie.

La figure 3 présente la courbe d'isolement entre les connexions d'entrée et de sortie dans un boîtier selon l'art connu, en fonction de la fréquence.

Les fréquences en GHz étant données en abscisse et l'isolement, exprimé en dB, étant donné en ordonnée, on voit que dans l'exemple choisi sur lequel les mesures ont été effectuées, c'est-à-dire en fonction du dessin et des cotes de boîtier, ce boîtier est inutilisable dans la région de 10 GHz et présente une seconde bande interdite aux environs de 15 GHz.

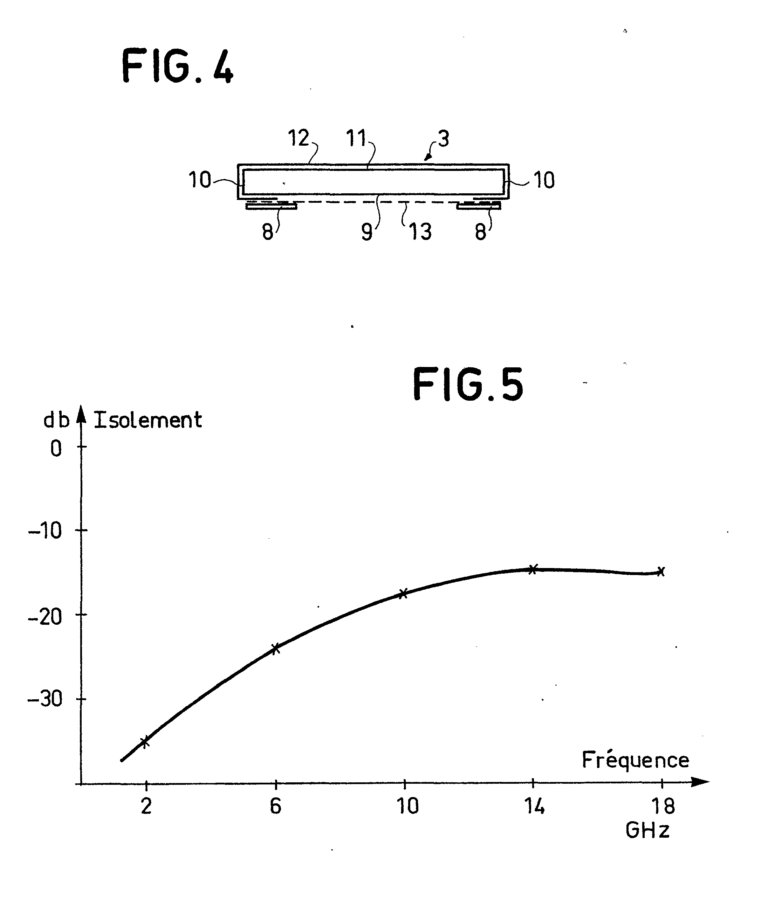

La solution retenue au titre de l'invention et illustrée en figure 4 consiste à métalliser en 12 la surface extérieure 11 et les tranches latérales 10 de la plaquette de céramique qui constitue le couvercle 3 du boîtier selon l'invention, représente en figure 1.

A partir d'une plaquette de céramique 3, une métallisation 12 consistant en une couche de nichrome, résistive à 80 ohms par carré, et de 500 Å d'épaisseur est déposée sur la face externe 11 de la plaquette céramique 3 et sur les tranches latérales 10, cette métallisation débordant légèrement sur la face intérieure 9 du couvercle. La métallisation par une couche de nichrome peut être pratiquée par différents procédés connus de l'homme de l'art, y compris le dépôt d'une encre résistive par sérigraphie: la résistivité est comprise entre 25 et 100 ohms/carré et son épaisseur comprise entre 100 et 5000 Å en fonction de sa composition et des dimensions du boîtier. Lorsque la métallisation résistive a été déposée sur le couvercle 3, le ruban de métallisation 8 est ensuite déposé selon les méthodes de l'art connu, en prenant soin qu'il y ait un contact électrique entre la partie de métallisation qui déborde sur la face intérieure 9 et le ruban de métallisation 8 déposé sur cette même face.

Ainsi, si l'on considère à nouveau le schéma théorique de la figure 2, le chemin entre le condensateur d'entrée $C_1$ et le condensateur $C_2$ de sortie comporte désormais une ligne de propagation dispersive. Il y a donc amortissement dans le système de couplage entre ces deux condensateurs.

Une unique surface de métallisation 13 représentée en pointillé, peut également être déposée non pas sur la surface extérieure du couvercle par rapport au boîtier fermé mais sur la surface intérieure 9 de ce même couvercle. En fait, la métallisation la plus commode étant en nichrome, et les soudures les plus fréquemment utilisées pour ce genre de scellement étant en or/étain, il se fait que, au cours de la fusion de la soudure, l'or/étain mouille la feuille de nichrome déposée sur la surface intérieure 9, ce qui a pour effet de court-circuiter en partie la ligne de propagation dispersive, et par conséquent de détruire en partie l'amélioration apportée à l'isolement entre les connexions d'entrée et de sortie. Cependant, la métallisation 13 de la face intérieure 9 du couvercle est tout à fait concevable et donne d'excellents résultats à la condition de changer d'alliage de soudure et d'utiliser par exemple des alliages à base d'or/germanium qui ne mouille pas le nichrome.

La figure 5 représente les résultats obtenus avec un boîtier d'encapsulation selon l'invention, les conditions de géométrie du boîtier et les conditions de mesure étant en tous points comparables entre la figure 3 et la figure 5.

On voit sur cette figure 5 que la courbe d'isolement entre 2 et 18 GHz est parfaitement monotone et ne présente plus de bandes interdites à une fréquence donnée. L'invention permet donc de travailler avec des semiconducteurs de type GaAs encapsulés dans des boîtiers étanches jusqu'à au moins 20 GHz, alors que jusqu'à présent pour des fréquences élevées et pour des semiconducteurs de puissance, le boîtier était souvent laissé ouvert, ce qui présentait donc des inconvénients puisque la pastille n'était plus protégée de façon climatique et mécanique.

L'invention a été décrite en prenant l'exemple d'une pastille sur GaAs et un boîtier rectangulaire mais il est évident qu'elles s'applique de façon plus générale à n'importe quel type de semiconducteur travaillant à des fréquences supérieures à 2 GHz et quelles que soient leur puissance et la forme du boîtier. Elle est précisée par les revendications ci-après.

## Revendications

1. Boîtier d'encapsulation pour semiconducteur de puissance fonctionnant dans une gamme de fréquences de 2 à 20 GHz, comprenant une embase (1) sur laquelle est fixée la pastille semiconductrice, un cadre isolant (2) à travers lequel passent au moins deux connexions externes d'accès au semiconducteur, dites d'entrée (5) et de sortie (6), et un couvercle isolant (3), le couvercle (3) étant fixé sur le cadre (2) par soudure au moyen d'une métallisation (7) déposée sur la face libre du cadre (2) d'une métallisation (8) déposée sur la face (9) du couvercle (3) en regard du cadre (2), ce boîtier d'encapsulation étant caractérisé en ce que le couvercle (3) est recouvert par une métallisation résistive, déposée sur le matériau isolant du couvercle, et en contact électrique avec la métallisation (8) destinée à la fermeture du boîtier.

2. Boîtier d'encapsulation selon la revendication 1, caractérisé en ce que la métallisation résistive est déposée sur la face intérieure (9) du couvercle (3), face qui est en regard du cadre (2) sur le boîtier fermé.

3. Boîtier d'encapsulation selon la revendication 1, caractérisé en ce que la métallisation résistive est déposée sur la face extérieure (11) et sur les tranches latérales (10) du couvercle (3), et déborde sur la face intérieure (9) du couvercle (3) de façon à établir un contact électrique avec la métallisation (8) de soudure du couvercle.

4. Boîtier d'encapsulation selon l'une quelconque des revendication 1 à 3, caractérisé en ce que la métallisation résistive est constituée par un dépôt de nichrome, d'une résistivité comprise entre 25 et 100 ohms/carré.

5. Boîtier d'encapsulation selon l'une quelconque des revendications 1 à 3, caractérisé en ce que la métallisation résistive est constituée par un dépôt d'or/germanium sur une épaisseur comprise entre 100 et 5000 Å.

6. Semiconducteur de puissance fonctionnant dans une gamme de fréquences de 2 à 20 GHz, caractérisé en ce qu'il est encapsulé dans un boîtier selon l'une quelconque des revendications 1 à 5.

## Patentansprüche

1. Kapselungsgehäuse für eine Leistungshalbleiter, der in einem Frequenzbereich zwischen 2 und 20 GHz betrieben wird, mit einer Grundplatte (1), auf der das Halbleiterplättchen befestigt ist, mit einem isolierenden Rahmen (2), durch den mindestens zwei Außenanschlüsse, Eingangs- und Ausgangsanschlüsse (5 bzw. 6) genannt, zur Verbindung mit dem Halbleiter verlaufen, und mit einem isolierenden Deckel (3), der auf den Rahmen (2) mit Hilfe einer auf die freie Seite des Rahmens (2) aufgebrachten Metallisierung (7) und einer auf die dem Rahmen (2) zugewandte Seite des Deckels (3) aufgebrachten Metallisierung (8) aufgelöst ist, dadurch gekennzeichnet, daß der Deckel (3) mit einer als ohmscher Widerstand wirkenden Metallisierung bedeckt ist, die auf das isolierende Material des Deckels aufgebracht ist und mit der für den Verschluß des Gehäuses bestimmten Metallisierung (8) in Kontakt steht.

2. Kapselungsgehäuse nach Anspruch 1, dadurch gekennzeichnet, daß die als ohmscher Widerstand wirkende Metallisierung auf die Innenseite (9) des Deckels (3) aufgebracht ist, die dem Rahmen (2) bei geschlossenem Gehäuse gegenüberliegt.

3. Kapselungsgehäuse nach Anspruch 1, dadurch gekennzeichnet, daß die als ohmscher Widerstand wirkende Metallisierung auf die Außenseite (11) und auf die seitlichen Schnittflächen (10) des Deckels (3) aufgebracht ist und auf die Innenseite (9) des Deckels (3) übergreift, so daß ein elektrischer Kontakt mit der Lötmetallisierung (8) des Deckels hergestellt wird.

4. Kapselungsgehäuse nach einem beliebigen der Ansprüche 1 bis 3, dadurch gekennzeichnet, daß die als ohmscher Widerstand wirkende Metallisierung als Nichrom-Schicht mit einem spezifischen Widerstand zwischen 25 und 100 $\Omega$ pro Quadrat ausgebildet ist.

5. Kapselungsgehäuse nach einem beliebigen der Ansprüche 1 bis 3, dadurch gekennzeichnet, daß die als Widerstand wirkende Metallisierung als eine Gold/Germaniumschicht mit einer Dicke zwischen 100 und 5000 Å ausgebildet ist.

6. Leistungshalbleiter, der in einem Frequenzbereich zwischen 2 und 20 GHz betrieben wird, dadurch gekennzeichnet, daß er in ein Gehäuse nach einem beliebigen der Ansprüche 1 bis 5 eingekapselt ist.

## Claims

1. A capsule housing for a power semiconductor having operational frequencies from 2 to 20 GHz, comprising a base-plate (1) on which a semiconductor dice is mounted, an insulating frame (2) which is transversed by at least two outer connections, called input (5) and output (6), providing access to the semiconductor, and an insulating cover (3) which id fixed to the frame (2) by brassing by means of a metal layer (7) deposited on the free surface of the frame (2) and of a metal layer (8) deposited on the cover (3) surface (9) facing the frame (2), characterized in that the cover (3) is coated by a resistor metallisation which is deposited on the insulating material of the cover and which is in electric contact with the metallisation (8) for closing the housing.

2. A capsule housing according to claim 1, characterized in that the resistor metallisation is deposited on the inner cover (3) surface (9) which faces the frame (2) when the housing is closed.

3. A capsule housing according to claim 1, characterized in that the resistor metallisation is deposited on the outer cover (3) surface (11) and on the lateral edges (10) of the cover (3) and protrudes on the inner surface (9) of the cover (3) in order to establish an electric contact with the brass metallisation (8) of the cover.

4. A capsule housing according to any one of claims 1 to 3, characterized in that the resistor metallisation is constituted by a nichrome layer having a specific resistivity of between 25 and 100 $\Omega$ per square.

5. A capsule housing according to any one of claims 1 to 3, characterized in that the resistor metallisation is constituted by a gold/germanium layer having a thickness of between 100 and 5000 Å.

6. A power semiconductor having operational frequencies form 2 to 20 GHz, characterized in that it is encapsulated in a housing according to any one of claims 1 to 5.

0 065 443

# FIG.1

# FIG.2

# FIG.3

# FIG. 4

# FIG. 5